(19) Europäisches Patentamt
European Patent Office
Office européen des brevets

(11) **EP 1 343 252 B1**

(12) **EUROPEAN PATENT SPECIFICATION**

(45) Date of publication and mention
of the grant of the patent:
**22.08.2007 Bulletin 2007/34**

(51) Int Cl.:
*H03K 17/955* (2006.01)    *G01D 5/24* (2006.01)
*H03K 17/96* (2006.01)

(21) Application number: **03075592.0**

(22) Date of filing: **28.02.2003**

(54) **Non-contact obstacle detection system utilizing ultra sensitive capacitive sensing**

System zur kontaktlosen Hinderniserkennung mit hochempfindlicher kapazitiver Detektionsvorrichtung

Système de detection d'obstacles sans contact avec détection capacitive ultrasensible

(84) Designated Contracting States:
**DE FR GB**

(30) Priority: **05.03.2002 US 361803 P**
**10.05.2002 US 143141**

(43) Date of publication of application:
**10.09.2003 Bulletin 2003/37**

(73) Proprietor: **Delphi Technologies, Inc.**
**Troy, MI 48007 (US)**

(72) Inventors:
• **Haag, Ronald H.**
**Clarkston, Mi (US)**
• **Deplae, Brian**
**Warren, MI 48093 (US)**

• **Husic, Jeremy M.**
**Washington, MI 48094 (US)**
• **Pasiecznik, John**
**Malibu, CA 90264 (US)**

(74) Representative: **Denton, Michael John**
**Delphi European Headquarters,**
**64 avenue de la Plaine de France,**
**Paris Nord II,**
**BP 60059, Tremblay-en-France**
**95972 Roissy Charles de Gaulle Cédex (FR)**

(56) References cited:
**DE-A- 2 538 531         DE-A- 19 836 056**
**GB-A- 2 243 217         GB-A- 2 366 385**
**US-A- 4 305 007         US-A1- 2001 011 894**

## Description

BACKGROUND

The present disclosure relates generally to proximity detecting systems and, more particularly, to a flexible capacitive strip for use in a non-contact obstacle detection system, such as may be implemented in conjunction with a motor vehicle power lift-gate, power operated device, or perimeter system.

Various systems have been devised for detecting obstacles in the path of a moveable panel such as an automotive power window, power sliding door or power hinged door. When an obstacle is detected, forward movement (e.g., closing) of the panel is interrupted and, optionally, the movement of the panel may be thereafter reversed (e.g., opened). These detection systems may generally be characterized as either "contacting" or "noncontacting". In a contacting system, an obstacle is detected only after some form of physical contact occurs between the panel and the obstacle, and may include devices such as pneumatic/pressure sensitive strips, or possibly sensors responsive to changes in mechanical or electrical loading in the apparatus that moves the panel.

On the other hand, in a non-contacting system, an obstacle is detected before actual contact occurs. One specific type of non-contacting obstacle detection system employs the use of a capacitive element(s) as a proximity sensor(s). Capacitive proximity sensors may include one or more electrical conductors formed along the leading edge of an object, as well as a capacitance sensitive circuit coupled to the conductor(s). An obstacle in proximity to the conductor(s) changes the capacitance of the sensor, and the change is thereafter detected by the capacitive sensitive circuit.

Unfortunately, certain problems may arise in creating an appropriate capacitive proximity sensor having the requisite nominal, steady-state capacitance desired for high-sensitive applications, such as the non-contacting obstacle detecting system described above. First, the nominal capacitance value of a capacitive sensing device is inherently dependent upon (among other parameters) the physical dimensions and relative positions of the capacitor electrodes with respect to one another. More specifically, the degree to which the capacitor electrodes are dimensionally consistent with one another along their length will have an effect upon the characteristics of the device. Given the fact that a sensor could be located upon a contoured surface such as a vehicle pillar, panel or moveable lift-gate, the prospect of forming a reliable, sensitive capacitive proximity sensor can therefore be difficult.

Furthermore, it may also be desirable for the sensor to be located in a "tight" area that effectively limits the profile of the sensor, and/or provided in an outdoor setting (such as upon a motor vehicle) that is necessarily exposed to moisture. These variables also have an effect on capacitance and, as such, should be taken into account when designing a high-sensitivity, precision capacitive proximity sensor.

A prior art proximity sensor according to the preamble portion of Claim 1 is known from DE 2538531.

SUMMARY

The above discussed and other drawbacks and deficiencies of the prior art are overcome or alleviated by a capacitive sensor assembly. In an exemplary embodiment, the assembly includes a capacitive strip having an elongated body for flexible mounting to a panel along a bottom surface of the elongated body. A first elongated planar conductor is contained within an upper section of the elongated body, while a longitudinal cavity is formed through a central portion of the elongated body. The longitudinal cavity is disposed between the planar conductor and the bottom surface. A capacitance detector module is inserted within the longitudinal cavity, the capacitance detector module including a capacitance detector circuit therein that is coupled to the first elongated planar conductor.

In another embodiment, the first elongated planar conductor is a first electrode of a sensing capacitor coupled to the capacitance detector circuit. The longitudinal cavity comprises a portion of a dielectric material of the sensing capacitor. In addition, the panel comprises a second electrode of the sensing capacitor. The planar conductor is preferably a flexible material, such that a substantially constant distance is maintained between the first elongated planar conductor and the panel. The elongated body is formed by extrusion of an insulating material such as santoprene rubber.

In another aspect, the capacitance detector module further includes a printed circuit board and a shielding structure for shielding radiated emissions generated by devices contained within the printed circuit board. A terminal clip electrically connects the printed circuit board with the first elongated planar conductor. A first end of the terminal clip is attached to a back side of said printed circuit board, and a second end of the terminal clip is attached to the first elongated planar conductor. The shielding structure further includes a first shield for shielding a first oscillator included within the printed circuit board, and a second shield for shielding a second oscillator included within the printed circuit board.

The above discussed and other drawbacks and deficiencies of the prior art are also overcome or alleviated by a method for detecting a change in capacitance of a capacitive sensing element having a nominal capacitance value. In an exemplary embodiment, the method includes coupling the sensing element to a first oscillator, the first oscillator generating a first frequency dependent upon the capacitance value of the sensing element. The first frequency is compared to a reference frequency generated by a second oscillator. The change in capacitance from the nominal capacitance value is detected if the first frequency differs from said reference frequency by a determined frequency value.

In an exemplary embodiment, the first oscillator and the second oscillator are configured such that the first frequency and the reference frequency are offset from one another by a fixed offset value when the capacitance of the capacitive sensing element is equal to the nominal capacitance value. In addition, the first frequency and the reference frequency are inputted into a mixer. An output of the mixer is then inputted into a low pass filter, wherein an output of the low pass filter is an intermediate frequency (IF) that corresponds to the difference between the first frequency and the reference frequency. The intermediate frequency (IF) is preferably in the range of about 0 to about 15 MHz, while the first frequency and reference frequency are at least 900 MHz.

In still another embodiment, the intermediate frequency is transmitted to a control module where the intermediate frequency is then compared to the fixed offset value. Thereby, an increase in capacitance from the nominal capacitance value is detected if the intermediate frequency exceeds the fixed offset value.

The above discussed and other drawbacks and deficiencies of the prior art are also overcome or alleviated by a non-contact obstacle detection system utilizing ultra sensitive capacitive techniques. In an exemplary embodiment, the system includes a sensing element disposed in proximity to a moveable panel and a proximity detection circuit in communication with the sensing element. The proximity detection circuit generates a differential output signal reflective of whether a foreign object is in proximity to the sensing element. In addition, a central control module is in communication with the sensing element. The central control module determines whether the differential output signal is reflective of a foreign object in proximity to the sensing element. If the central control module determines that the differential output signal is reflective of a foreign object in proximity to the sensing element, and the moveable panel is moving toward a closed position, then the central control module generates a control output signal to stop the moveable panel from moving toward the closed position.

In an exemplary embodiment, the sensing element further includes a capacitive sensing element having a nominal capacitance, wherein the proximity detection circuit detects a change in the nominal capacitance as a result of a foreign object in proximity to the sensing element. The proximity detection circuit is integrated within the sensing element, and further includes a first oscillator, which generates a first frequency signal. The first frequency signal is dependent upon the capacitance of the sensing element. A second oscillator generates a reference frequency signal, wherein the differential output signal is determined from a comparison between the first frequency signal and the reference frequency signal.

Preferably, the obstacle detection system further includes a coaxial cable coupling the proximity detection circuit and the central control module, the coaxial cable transmitting both a DC power signal and the differential output signal. Both the proximity detection circuit and the central control module further include a bias "T" apparatus included therewith.

BRIEF DESCRIPTION OF THE DRAWINGS

Figure 1 is a partial perspective view of a flexible capacitive strip used in a capacitive sensor assembly, in accordance with an embodiment of the invention;

Figure 2a is a lateral cross-sectional view of the capacitive strip of Figure 1, shown mounted to a panel;

Figure 2b is a lateral cross-sectional view of an alternative embodiment of Figure 2a;

Figure 3 is an exploded perspective view of capacitance detector module to be inserted within the flexible capacitive strip;

Figure 4 is a side view of the capacitance detector module of Figure 3;

Figure 5 is a perspective view of both the capacitance detector module and the capacitive strip, illustrating the positional orientation of the insertion of the capacitance detector module into the capacitive strip;

Figure 6 is a side cross-sectional view of the capacitance detector module inserted within the capacitive strip to form the capacitive sensor assembly;

Figure 7 is another side cross-sectional view of the capacitance detector module inserted within the capacitive strip, further illustrating an end mold covering over the protruding end of the capacitance detector module and capacitor electrode;

Figure 8 is a perspective, cut away view of an alternative embodiment of the capacitive sensor assembly, further illustrating a coaxial cable and connector;

Figure 9 is an end view of an alternative embodiment of the capacitive strip;

Figure 10 is a schematic diagram of a non-contact obstacle detection system, including one or more capacitive sensing elements and associated high sensitivity capacitance detection circuits, in accordance with an embodiment of the invention;

Figure 11 is a block diagram of an exemplary high sensitivity capacitance detector (HSCD) along with the associated control module circuitry connected thereto;

Figure 12(a) is a schematic diagram illustrating one possible circuit implementation of the HSCD shown in Figure 11;

Figure 12(b) is a schematic diagram illustrating one possible circuit implementation of the associated control module circuitry shown in Figure 11;

Figure 13 is a functional block diagram of the non-contact obstacle detection system shown in Figure 10; and

Figures 14 through 20 are flow diagrams that illustrate exemplary subroutines related to a floating variable algorithm for compensating for environmental and structural changes.

DETAILED DESCRIPTION

A capacitive sensor assembly is disclosed herein. The capacitive sensor assembly is inexpensive to manufacture, and has a suitably low nominal capacitance (on the order of about 20 picofarads (pF), for example) while still maintaining three dimensional flexibility for mounting to a contoured surface such as on a motor vehicle. The sensor assembly is embodied by a flexible capacitive strip that has a relatively low profile so as to be able to fit between, for example, a vehicle pillar and a door that closes upon the pillar. The strip is preferably formed so as to provide moisture resistant protection for the electrode(s) contained therein. In a further aspect, the capacitive sensor strip is also configured for integrally housing capacitance detection circuitry therein. Thereby, the capacitive strip may be connected directly to the detection circuitry, providing additional advantages as described hereinafter.

Also disclosed herein is a method and apparatus for detecting a relatively small change in the capacitance of a capacitive sensing element, such as may be found in a non-contact obstacle detection system.

Further disclosed herein is a non-contact obstacle detection system that utilizes ultra sensitive capacitance techniques to control the movement of an electrically powered system such as power lift-gates, power sliding doors, power deck lids, or a moving door of a vehicle. Generally speaking, the system is based on an ultra sensitive capacitive detection technique, in which a proximity detection circuit is integrated directly into a capacitive sensing element. The capacitive sensing element may be embodied, for example, by a capacitive strip flexibly mounted to a metal panel such as a motor vehicle pillar or a lift-gate. When a foreign object (e.g., a human hand) comes in proximity to the sensor element while the powered door is closing, an electrical signal is generated by a central control module. This signal is then sent to another control module controlling the movement of the power lift-gate, causing the control module to stop the closing operation.

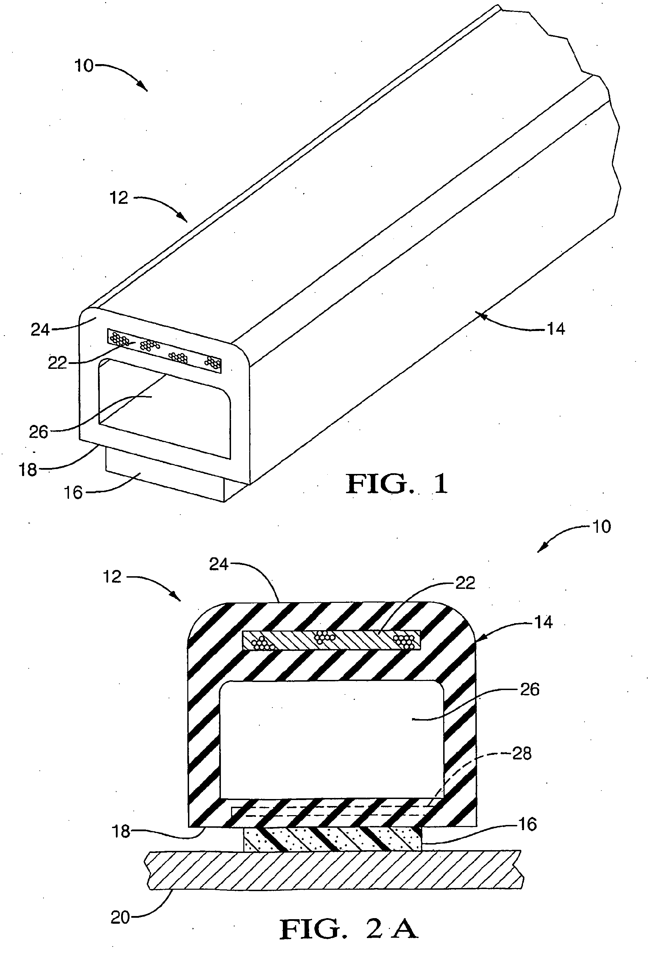

Referring initially to Figures 1 and 2a, there is shown a perspective and a lateral cross-sectional view (respectively) of a capacitive sensor assembly 10 including a flexible capacitive strip 12. In accordance with an embodiment of the invention, the sensor strip 12 has a flexible, elongated body 14 with an adhesive strip 16 affixed to a bottom surface 18. The adhesive strip 16 provides a means for securing the strip 12 to a metal panel 20 (e.g., a motor vehicle pillar or lift-gate). The sensor body 14 is preferably formed by extrusion of an insulating, flexible material such as santoprene rubber.

A flexible conductor 22 serves as a first electrode of the capacitive sensor assembly 10, and is insert molded into an upper portion 24 of the sensor body 14. The conductor 22 is further disposed substantially parallel to the bottom surface 18 and thus should be substantially parallel to the metal panel 20 when the strip 12 is attached thereto, regardless of the particular contours of the panel 20. Preferably, conductor 22 is a flat, braided conductor of tinned copper or the like so as to be flexible in any direction without being damaged, and without resulting in any change to its electrical characteristics along the length thereof. One example of a suitable choice for conductor 22 includes a flat tinned copper braid manufactured by the Alpha Wire Company. The santoprene rubber sensor body 14 covers the entire surface of the flat braid conductor 22 to prevent it from being exposed to moisture and, in addition, the extrusion of the rubber provides a cost effective method for producing several strips 12 (that may be cut to a desired length) from a single process.

In addition to containing the flexible conductor 22, the sensor body 14 further includes a central longitudinal cavity 26 between the upper portion 24 and the lower surface 18. In one aspect, the cavity 26 acts as an air core (i.e., dielectric) separating the conductor 22 from the metal panel 20. In this particular embodiment, the metal panel also serves as a second electrode or ground plane of the capacitive sensor assembly 10. However, it should also be appreciated that in applications where the strip 12 is to be affixed to a non-metallic panel or a non-metallic carrier, a second elongated conductor may be insert molded into the body 14 between the cavity 26 and the bottom surface 18, as is indicated in phantom by the conductor 28 in Figure 2a.

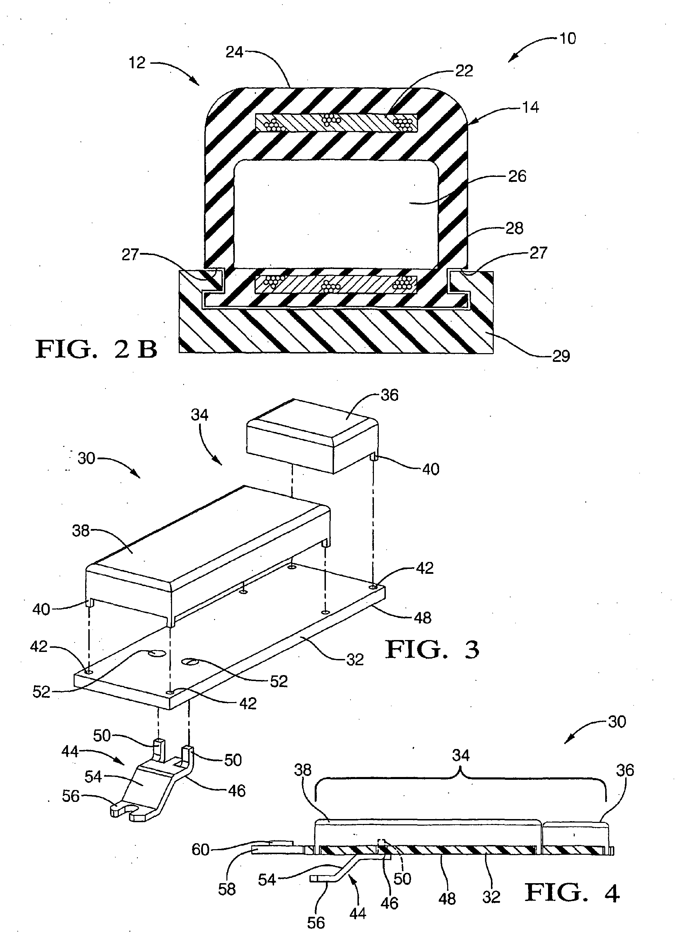

Figure 2b illustrates an alternative embodiment of Figure 2a. Instead of attaching the strip 12 to a metal panel by means of an adhesive strip, the sensor strip 12 may include grooves 27 formed within the outer sides of body 14. The strip 12 may then be slid (by way of grooves 27) into a plastic carrier 29 that holds the strip in place. In turn, the plastic carrier 29 may then be attached to a vehicle surface (not shown), for example, at an appropriate place. It will be noted, however, that in this embodiment, the conductor 28 is used as the second capacitor electrode as there is no direct contact between the strip 12 and a metal surface.

In general, the capacitance C of the sensor strip 12 may be determined from the following equation:

$$C = (\varepsilon_o \, \varepsilon_r \, A)/d$$

where $\varepsilon_o$ is the permittivity of free space (8.85 pF/m), $\varepsilon_r$ is the relative permittivity (dielectric constant) of the material(s) used to form the strip body 14 (in this case, air and santoprene rubber), A is the surface area of the braided conductor 22, and d is the distance between the electrodes of the capacitor within the sensor assembly 10. In the embodiment wherein the panel 20 forms the ground plane of the strip 12, d is the distance from the braided conductor 22 to the panel 20. Alternatively, d is the distance from the braided conductor 22 to the second braided conductor 28.

Accordingly, it will be appreciated that the above described configuration for the capacitive strip 12 is advantageous in that its flexibility allows it to conform to the profile of a contoured surface such as a motor vehicle while still providing a uniformly shaped conductor therein that can remain substantially parallel to the contoured surface itself. Moreover, the santoprene rubber material, among other advantages, provides protection for the conductor from outside elements, such as moisture, which could otherwise adversely affect the sensitivity of the sensor assembly 10. It will further be noted that the size of the strip may be tailored according to the specific application, taking into consideration the value of capacitance desired to be used in the sensing circuitry. For example, a capacitive strip 12 intended for use in a capacitive proximity sensor for a motor vehicle lift gate may have a width of about 10 millimeters (mm) and a thickness or height of about 8 mm. Again, however, it will be understood that the general configuration for the capacitive strip may have several other applications and, thus, other sizes.

When the capacitive strip 12 is used in conjunction with some type of capacitance detection circuitry, an external connection may be needed to connect the conductor 22 to the circuitry. Accordingly, any external wire, lead, or other connection to conductor should also be provided with a sealing material so as to maintain the protection of the conductor 22 from moisture and other conditions. This is also the case for any end of the strip 12 that has been cut to a desired length; a cut end of the strip 12 is preferably also provided with a protective end mold (e.g., rubber) to seal the tip of the conductor 22.

In certain applications of capacitance detection systems, it may be the case that the sensing circuitry utilizes one or more high frequency (e.g., > 900 MHz) oscillation devices to detect changes in capacitance. If the circuitry is located remotely from the capacitive strip 12 and relatively locally with respect to other electronic components and wiring, there is the possibility that radiated emissions from the oscillation devices could interfere with the other electronic components and associated wiring. While extensive shielding could be used in a control module, for example, to isolate multiple high frequency devices, it may also be desirable to locate a capacitance detector circuit in proximity with the capacitive strip 12 itself.

Therefore, in accordance with a further aspect of the invention, the sensing apparatus 10 is further provided with a high-sensitivity capacitance detector circuit module (hereinafter referred to as the HSCD module) integrated therein. Generally speaking, the packaging of the HSCD module is designed to be inserted into the central longitudinal cavity 26 of strip 12. Thereby, the HSCD may be directly connected to conductor 22 (i.e., capacitor electrode). In this manner, the potential for variation in nominal capacitance value is also reduced since there is no need for a length of external conductive wire to connect the strip 12 to a remotely located detector circuit.

Referring now to Figures 3 and 4, the HSCD module 30, in one possible embodiment, includes a printed circuit board 32 containing the individual HSCD circuit components (not shown) and interconnections therebetween. A shielding structure 34 includes a first shield 36 for shielding a first oscillator and a second shield 38 for shielding a second oscillator. For example, the HSCD module 30 may include one or more oscillator devices and, thus each device is provided with an individual shield. Both the first shield 36 and the second shield 38 include tabs 40 that are inserted into corresponding holes 42 within the printed circuit board 32.

In addition, the HSCD module 30 is further provided with a terminal clip 44 or connection mechanism for electrically connecting the conductor 22 within the capacitive strip 12 with the capacitance detection circuitry within the HSCD module 30. A first end 46 of the clip 44 is mounted to the back side 48 of the printed circuit board 32 by inserting the tabs 50 on the clip 44 through corresponding holes 52 in the printed circuit board 32 and then forming a solder connection. However, any suitable attachment means to the printed circuit board 32 is also contemplated, such as by crimping or pressing. The clip 44 further includes an angled portion 54 that terminates in a second, horseshoe shaped end 56. In turn, the second end 56 is configured to be connected to the conductor 22 within the capacitive strip 12, as will be shown in further detail hereinafter. However, the second end 56 need not be horseshoe shaped, so long as the connection results in a consistent, steady state capacitance value.

As shown in Figure 4, an extension 58 may also be provided with printed circuit board 32. Extension 58 includes a connection port 60 that is configured for receiving a signal and power connection from a control module (not shown) to interface with the capacitance detector circuitry.

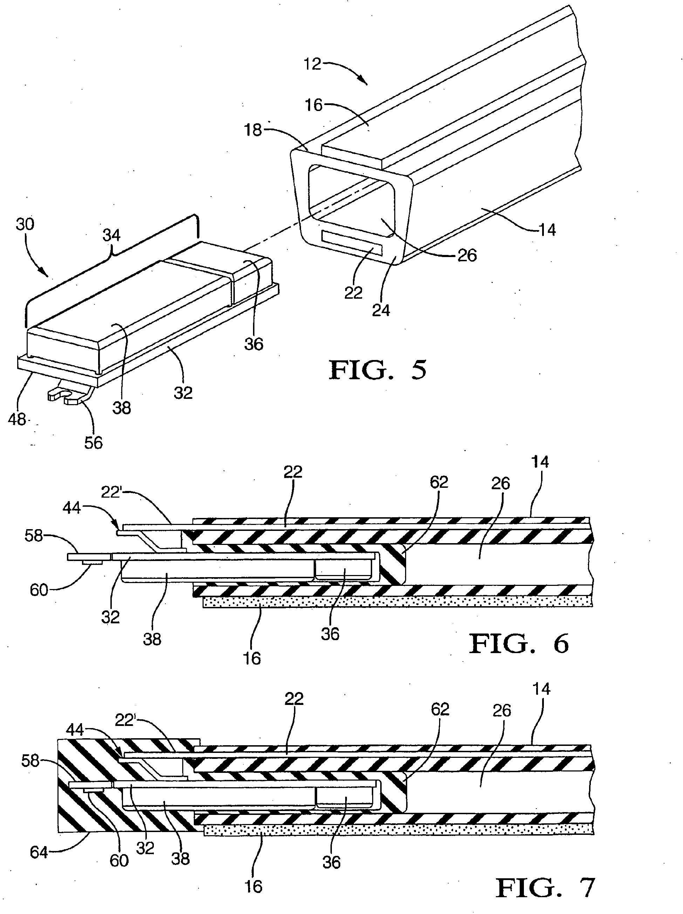

Referring now to Figure 5, there is shown a perspective view of both the HSCD module 30 (shown without extension 58 and connection port 60) and the capacitive strip 12, particularly illustrating the positional relationship therebetween when the module 30 is inserted within the cavity 26 of the strip 12. It will be noted that the strip 12 is "inverted" with respect to the module 30 and vice versa. In other words, the bottom surface 18 of the strip 12 is nearest the top of the shielding structure 34.

Figure 6 illustrates the inserted module 30 within the strip 12. However, prior to the insertion, the HSCD module 30 is first inserted into a rubber boot 62. The rubber boot 62 serves to secure the HSCD module 30 snugly within the cavity 26 of the strip, since the overall shape of the module 30 might not be identical with the shape of the cavity 26. The boot 62 will also serve to prevent the leakage of rubber inside the strip 12 when the end thereof is over-molded to seal the HSCD module 30 and the external connection thereto.

In order to make the connection between the terminal clip and the conductor 22, a portion 22' (e.g., about 8 mm) of the conductor 22 is exposed. This may be done during the extrusion process as the strip 12 is cut to its desired length. Thus, when the HSCD module 30 and covering boot 62 is inserted within the cavity 26 of the strip, the second end 56 of the terminal clip 44 is brought into contact with exposed portion 22' of conductor 22. A soldering process may then be implemented to assure good electrical connection between the conductor 22 and the terminal clip 44. The horseshoe configuration of second end 56 allows for easy solder flow to make the connection. Then, the longitudinal ends (only one shown) of the strip 12 are over-molded to form the insulative end caps 64 (only one shown) in Figure 7. The end 64 prevents moisture from entering the capacitive strip 12, as well as provides environmental protection for the protruding end of the HSCD module 30.

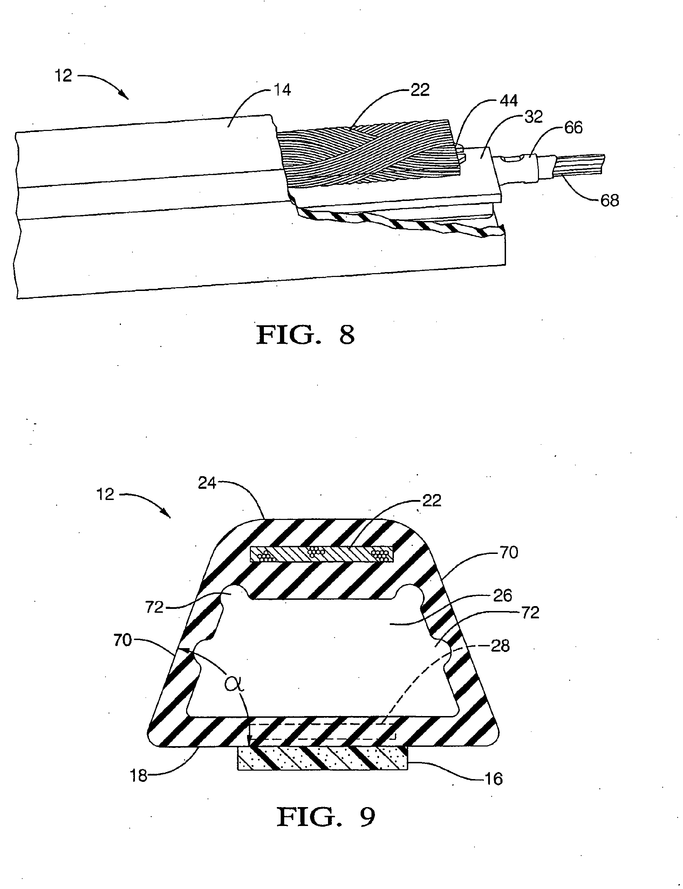

Figure 8 illustrates still an alternative embodiment of the inserted module 30 within the strip 12. A coaxial cable connector 66 and associated cable 68 may be used to both provide power to the HSCD module 30 and to transmit the signals generated therein. The coaxial cable 68 is a preferred, lower cost alternative to multiple wiring configurations.

Finally, Figure 9 illustrates an end view of an alternative embodiment of the capacitive strip 12. The capacitive strip 12 may have a cross section that is generally trapezoidal in shape, wherein the side surfaces 70 of the strip are upwardly tapered as determined by an acute angle, $\alpha$, with respect to the bottom surface 18. In addition, the cavity 26 may be formed to include curved protrusions 72 within the material of the strip 12. Thus configured, strip 12 may be made more resistant to inward compression of the side surfaces 66. If pressure is applied to the upper portion 24 of the strip 12, the upper portion 24 will move straight downward, but will more readily return to its original position when the compressive force is removed.

Although the following disclosure is described in the context of an obstacle detection system for use in conjunction with a power door or gate of a motor vehicle, it will be understood that present invention embodiments are equally applicable to any proximity detection system and, more generally, to any system using one or more capacitive sensing elements.

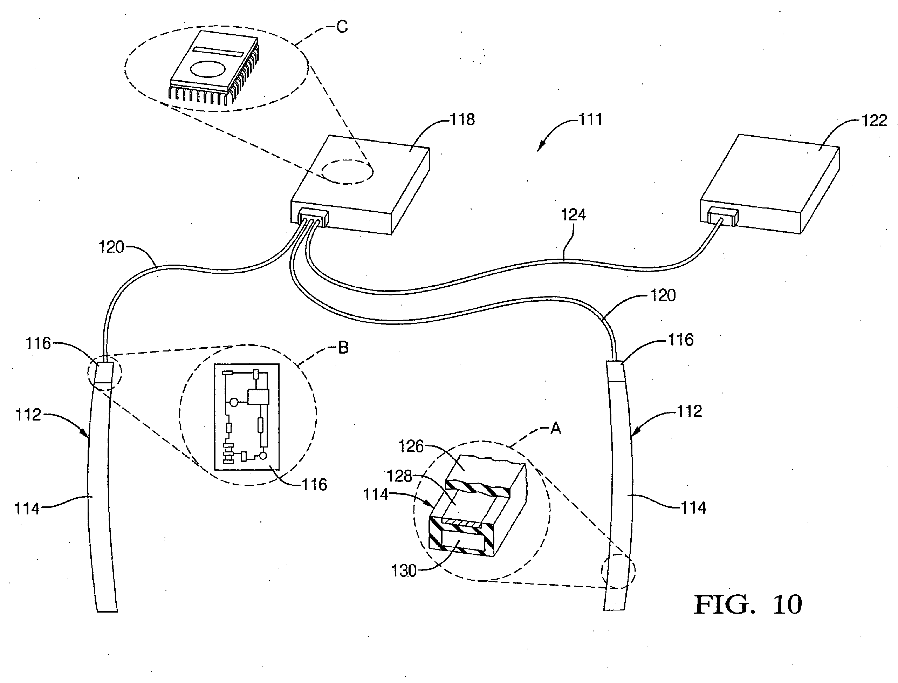

Referring initially to Figure 10, there is shown a schematic diagram of a non-contact obstacle detection system 110, which could be implemented, for example, in conjunction with a motor vehicle power door assembly. The obstacle detection system 110 may include one or more capacitive sensing elements 112, each configured to have a desired nominal capacitance value. Each individual capacitive sensing element 112 further includes a flexible capacitive strip 114 (as highlighted in insert "A") having a high sensitivity capacitance detector (HSCD) circuit 116 integrated therein. The HSCD circuit 116 is symbolized in insert "B".

The sensing elements 112 are each coupled to a central control module 116 through lines 120. As is described in greater detail hereinafter, the lines 120 preferably include a twisted pair of conductors or, alternatively, a length of coaxial cable. In either case, the lines 120 provide a means of supplying a direct current (DC) power signal from the central control module 118 to the HSCD circuit 116. Furthermore, the central control module 118 receives an output signal from each of the sensing elements 112 through lines 120, and determines whether there is a detected change in capacitance of any of the sensing elements 112. In the event that a foreign object is in proximity to one or more sensing elements 112 during a closing operation of a power door or panel, the central control module 118 will generate a command signal to stop the closing operation. This may be accomplished, in one embodiment, by coupling the central control module 118 to a power door control module 122 through a data line 124.

Generally speaking, the central control module 118 will preferably include computer hardware and associated software therein (represented symbolically in insert "C") for comparing output signals from the HSCD circuits 116 to nominal values stored in lookup/profile tables.

As shown in insert "A", the flexible capacitive strip 114 (in one possible embodiment) may be formed by extruding an insulating, flexible material 126 (such as santoprene rubber) around a flat conductor 128. The conductor 128 serves as one capacitor electrode of the capacitive sensing element 112. The conductor 128 is further designed to be substantially parallel to a surface (not shown), along the entire length of the strip 114, when the strip 114 is affixed to the surface. In one embodiment, the conductor 128 serves as one capacitor electrode, while the surface (e.g., a metallic vehicle body) serves as the other electrode. An air cavity 130 within the strip 114 serves, in one aspect, as a dielectric material between the capacitor electrodes.

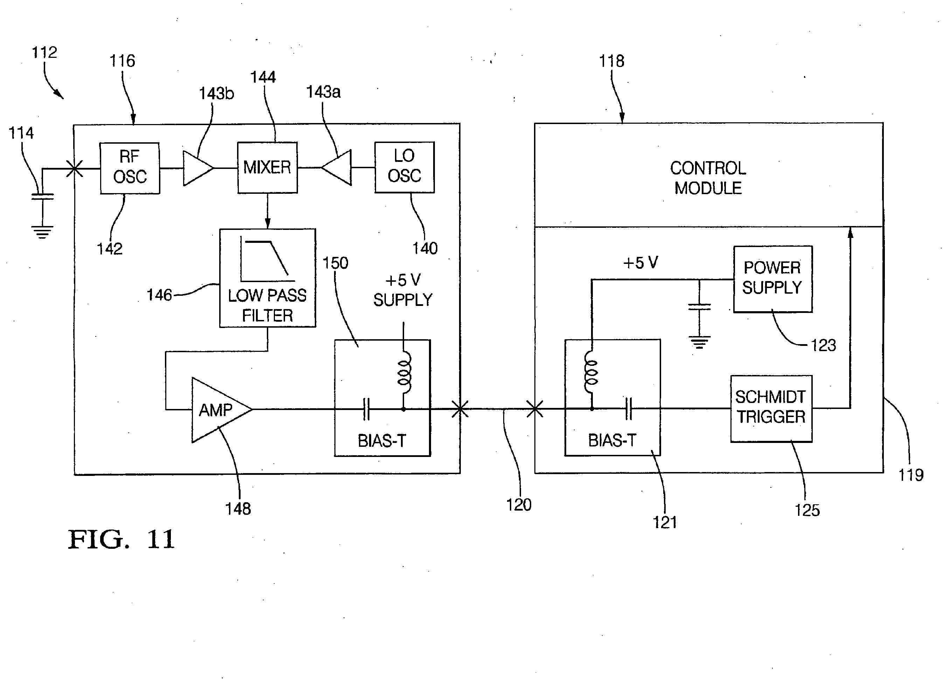

Referring now to the block diagram of Figure 11, the HSCD 116 includes a fixed (local) oscillator 140, a variable (RF) oscillator 142, a mixer 144, a low pass filter 146, gain stage 148, and a bias "T" arrangement 150. The fixed oscillator 140 produces a frequency output that is stable in nature. By way of example, the frequency of the fixed oscillator 140 may be set at a fixed frequency, $f_{LO}$, of about 925 MHz. However, it can be set at any desired frequency. The variable oscillator 142 is coupled to the capacitive strip 114 of a capacitive sensing element 112 as described above, such that the variable oscillator 142 generates an output frequency that is dependent upon the capacitance value of the capacitive strip 114. In a preferred embodiment, the variable oscillator 142 is set up to generate a frequency, $f_{RF}$, of about 922 MHz (or, in other words, at a fixed offset of about 3MHz from the fixed oscillator) in a steady state environment. A "steady state" environment refers to a condition wherein there is no foreign object in proximity to a given sensing element 112. In such a situation, the capacitance value of the strip 114 remains at its nominal value as determined by its physical parameters, and )C = 0.

If a hand or other foreign object approaches the sensor strip 114, the capacitance value thereof will increase such that )C 0. As a result, the output frequency, $f_{RF}$, of the variable oscillator 142 is also changed such that )$f_{RF}$ is proportional to )C. More specifically, an increase in the capacitance of the sensor strip 114 will cause the output frequency, $f_{RF}$, of the variable oscillator 142 to decrease.

Both the fixed oscillator output frequency and the variable oscillator output frequency are fed through return loss attenuators 143a and 143b, respectively, and inputted into mixer 144 where the two signals are both subtracted and added together. As is well known in the art, mixers are used in RF communication technology to shift a baseband information signal to a frequency or frequencies suitable for electromagnetic propagation to the desired destination. In this case, the frequency to be shifted is the variable frequency $f_{RF}$. When mixed with the output of the fixed (i.e., local) oscillator 140, the result is two outputs at the intermediate frequency (IF) port of the mixer 144. These IF outputs may be represented as $f_{LO}$ + $f_{RF}$ and $f_{LO}$ - $f_{RF}$. In a steady state mode, therefore, the resulting mixer output frequencies are about 3 MHz and 1847 MHz.

If the desired IF signal is higher than the RF signal, the mixer is considered an upconverter; if the desired IF signal is lower than the RF signal, then the mixer is considered a downconverter. As is described hereinafter, the desired IF component for the present HSCD 116 is the frequency difference between the local oscillator 140 and the fixed oscillator 142. Thus, frequency down conversion is applied by inputting the output of the mixer 144 through the low pass filter 146 in order to pass through the difference of the two frequencies. The low pass filter 146 is preferably designed such that a capacitance change seen at a sensing element 112 (and resulting frequency change of the variable oscillator 142), caused by the presence of a foreign object, is recognized and detected in the form of a change (i.e., increase) in $f_{LO}$ - $f_{RF}$.

The output of the low pass filter 146 is then amplified by gain stage 148 before being transmitted to the control module 118 for processing. As will be noted later, the low pass filter 146 can also be configured to be part of the feedback network of gain stage 148. The bias "T" arrangement 150 is incorporated to reduce the number of wiring connections used to couple the control module to the HSCD. As is known in the art, a bias "T" is used to couple a DC voltage onto the same transmission line used for AC (RF) signals, or to detect/remove the DC component of a composite signal. Thus, if a bias "T" is used, a two-wire twisted pair conductor may be used for lines 120 to couple the control module 118 to the HSCD 116. Alternatively, a coaxial cable may be used.

In a simple form, a bias "T" may include an inductive choke or, for frequencies exceeding 1 GHz, specifically tuned elements on a circuit board. Additional information on bias "T" arrangements may be found in U.S. Patent 6,229,408 to Jovanovich, et al. It will be appreciated that, if multiple sensing elements 112 are used in system 110, then the central control module 118 will include a multiple bias "T" arrangement. In the present embodiment, the AC signal output from gain stage 148 travels through the bias "T" 150 to the control module 118, while a 5-volt (for example) DC signal is sent from the control module 118 to the HSCD 116 to provide power thereto.

As shown in Figure 11, the control module 118 further includes a front-end electronics area 119 having a corresponding bias "T" 121. An internal power supply 123 provides a regulated, +5V output voltage for use by the HSCD 116. On the receiving side, bias "T" 121 also strips off the incoming IF signal from the HSDC 116, so that the IF signal may be passed through a Schmidt trigger 125 and then on to digital processing by software within the control module 118.

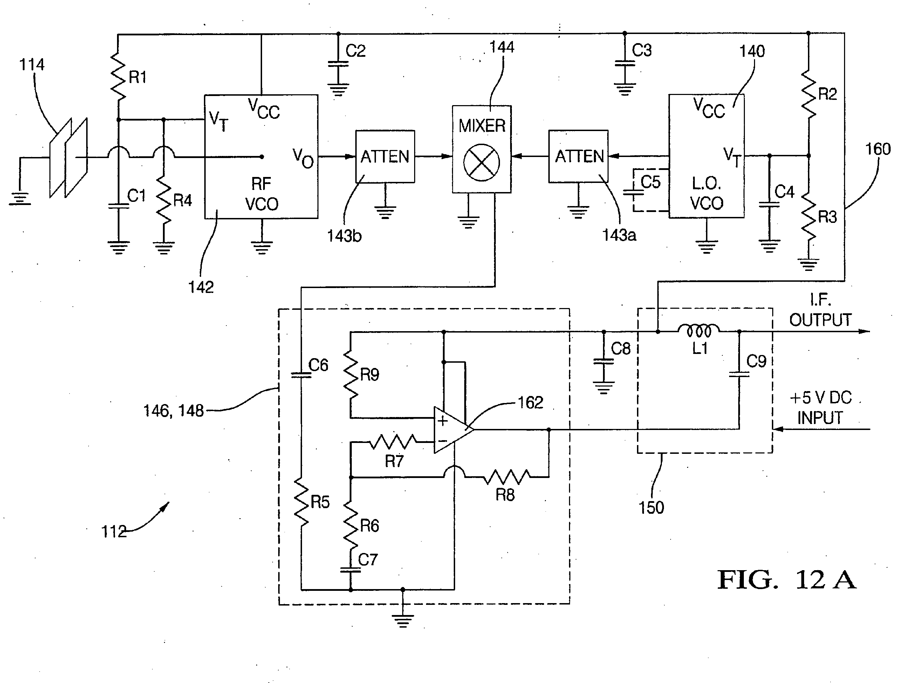

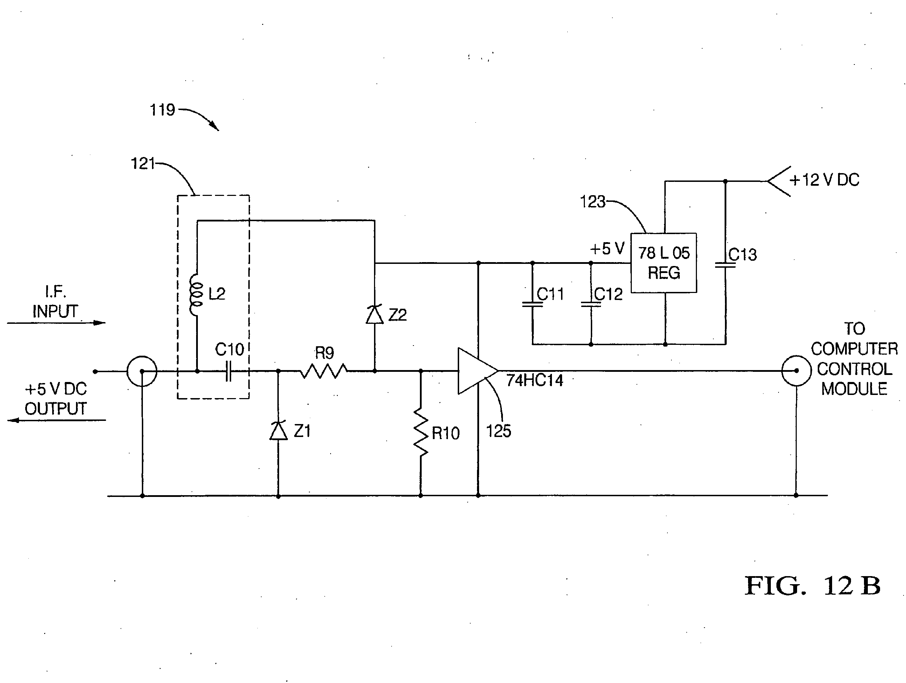

Referring now to Figure 12(a), there is shown one possible circuit embodiment that realizes the block diagram functions of the HSCD 116 illustrated in Figure 12. As is shown, the bias "T" 150 includes coupling capacitor C9 and inductor L1. Capacitor C9 couples the output IF signal from low pass filter 146 and gain stage 148 onto the signal line, while the inductor L1 provides a high AC impedance so as to prevent the IF signal from being fed back onto the +5V DC bus 160. An exemplary value for L1 is about 220 microhenries ($\mu$H), while C9 may be chosen to be about 0.047 microfarads ($\mu$F).

A plurality of filter capacitors C1, C2, C3 and C4 are used to reduce any ripple effects on the DC bus 160 that could be generated by the RF oscillator 142 and the local oscillator 140. Particularly, C2 and C3 also serve to isolate one oscillator from the other. The capacitance values of C1 through C4 are relatively small (e.g., 0.1 $\mu$F) as compared to that of capacitor C8 (e.g., 3.3 $\mu$F), C8 being used to store the DC energy supplied to the HSCD.

Figure 12(a) further schematically illustrates the capacitive strip 114 coupled to the RF oscillator 142. Although not shown, a series capacitor is preferably coupled between the capacitive strip 114 and the RF oscillator 142, thereby forming a capacitive divider, in order to reduce the sensitivity of the circuit and to keep radiated emissions in the FCC approved band. In addition, resistors R1 and R4 (e.g., 2.1 k$\Omega$ and 1.2 k$\Omega$, respectively) are configured as a voltage divider to provide a trim point for the RF oscillator 142.

The local oscillator 140 is preferably buffered down with a bias loading so as to maintain a steady state, 3MHz offset from the RF oscillator 142. Accordingly, an external capacitor C5 (having an exemplary capacitance of about 30 pF) is coupled to the local oscillator 140. Resistors R2 and R4 (e.g., 2.1 kΩ and 560 Ω, respectively) are configured as a voltage divider to provide a trim point for local oscillator 140.

Although the obstacle detection system 111 utilizes environmental compensation software in its control module 118, an additional measure of compensation for variation in operating conditions (e.g., temperature changes) is provided by using the same type of oscillator for both the RF oscillator 142 and the local oscillator 140. In so doing, the effect on the output frequency of the local oscillator 140 (for example, as the result of a temperature change) will not affect the frequency difference between the RF oscillator 142, since the temperature change should have the same effect on the output frequency of the RF oscillator 142.

The low pass filter 146 and gain stage 148 are shown in Figure 12(a) as an integrated element. A first order, low pass filter is configured by coupling capacitor C6 to the output of mixer 144. The capacitance value of C6 may be chosen to be about 30 nanofarads (nF) to provide a 3 dB signal attenuation at around 10 MHz. The gain stage 148 includes an operational amplifier 162, with associated bias resistors R4 and R5, feedback resistors R6, R7 and R8, and feedback filter capacitor C7.

Finally, Figure 12(b) is a schematic diagram illustrating one possible circuit implementation of the associated control module circuitry 119 shown in Figure 11. The corresponding bias "T" 121 therein includes inductor L2 and capacitor C10. A pair of zener diodes Z1, Z2 provide voltage regulation for the output of power supply 123, as well as the Schmidt trigger 125. Capacitor C11, C12 and C13 further provide filtering for the power supply 123, which illustrates (by way of example) a +12 VDC input voltage, common in automotive systems.

It should be understood that the circuit shown in Figure 12(a) represents but one exemplary implementation of the HSCD, and those skilled in the art will recognize that several alternative circuit configurations are possible and may be configured to fall within the scope of the present invention embodiments.

As will be appreciated from the foregoing description, the HSCD method and apparatus takes advantage of frequency down conversion to allow for sufficient sensitivity to detect small changes in capacitance, while providing for the high frequency components (local oscillator 140, variable oscillator 142) to be localized at the sensing elements. In other words, a change in sensor strip capacitance, initially represented by a small frequency change in the output of the variable oscillator 142, is down converted to an intermediate frequency (IF) that is more suitable for use by the remaining portion of the overall system. Accordingly, the frequency down conversion technique keeps the 900 MHz signals contained within the HSCD 116, while the difference signal $f_{LO} - f_{RF}$ is the only frequency transmitted to another area of the vehicle. Since the difference signal ranges only from about 0 to about 15 MHz, it is possible (with the bias "T") to use a twisted pair for the signal transmission to the central control module 118, thereby providing a more cost effective alternative to a coaxial cable and connector system. Of course and in an alternative embodiment, the circuit or system can be adapted to operate outside the aforementioned range.

It should also be understood, however, that although a preferred frequency range of operation has been discussed, the HSCD will operate at any frequency. The embodiments discussed operate in the 902-928 Mhz ISM band, set aside by the FCC for field disturbance sensors. This band is wide enough to accommodate the swing of the RF oscillator. At lower frequencies, however, the swing may exceed the specified FCC band limits. Moreover, the 900 MHz band allows for a higher radiated power level than at lower frequencies. While the sensitivity of the HSCD is not dependent upon the oscillator power level, the FCC does regulate the maximum radiated power level.

Another benefit of the present design is that a clean digital signal is transmitted to the central control module 118. Smooth edges due to a sine wave limits 2nd and 3rd order harmonics to acceptable levels to meet the radiated emission requirements included the FCC regulations and applicable OEM specifications. In addition, variances in the power supply parameters (ripple or voltage drops) do not change the output signal frequency in the present design, since both oscillators will shift up or down in frequency as a result of any the above mentioned conditions. In other words, system sensitivity is not dependent on specific the power levels present thereon, provided the oscillators remain stable.

Still a further benefit of the present HSCD design is that the proximity detection system is self-adjusting for environmental conditions. Since the low pass filter 146 is designed to have a bandwidth of 15 MHz (although a wider bandwidth may be chosen if desired) and the steady state frequency difference, $f_{LO} - f_{RF}$, is set up at approximately 3 MHz, a 2 MHz change (decrease) in $f_{RF}$ is sufficient to determine that an obstacle is in proximity to the sensor element. Accordingly, the dynamic range of the HSCD may be increased and $f_{LO} - f_{RF}$ may be set to allow for environmental changes such as temperature change, mud splattering, light rain, and other conditions.

It should also be pointed out that the sensor strip design itself is of particular concern with regard to the functioning of the HSCD 116. The steady state capacitance value of the strip 114 should not be too large so as to swamp out the RF oscillator. If the capacitance value is too large, then the RF oscillator 142 could be pulled down and prevented from operating at the proper frequency, thereby becoming unstable. Thus, the impedance of the strip 114 is preferably chosen from about 50 ohms (Ω) to about 200Ω. An impedance of about 200Ω provides more device sensitivity due to a lower capacitance value, but the output radiated power is increased. At 50Ω, the radiated power is reduced, but the device sensitivity decreases due to a larger steady state capacitance, thereby limiting the operating frequency range. Accordingly, a strip 114 having a characteristic impedance of about 100Ω provides a good compromise for sensitivity and radiated emission concerns.

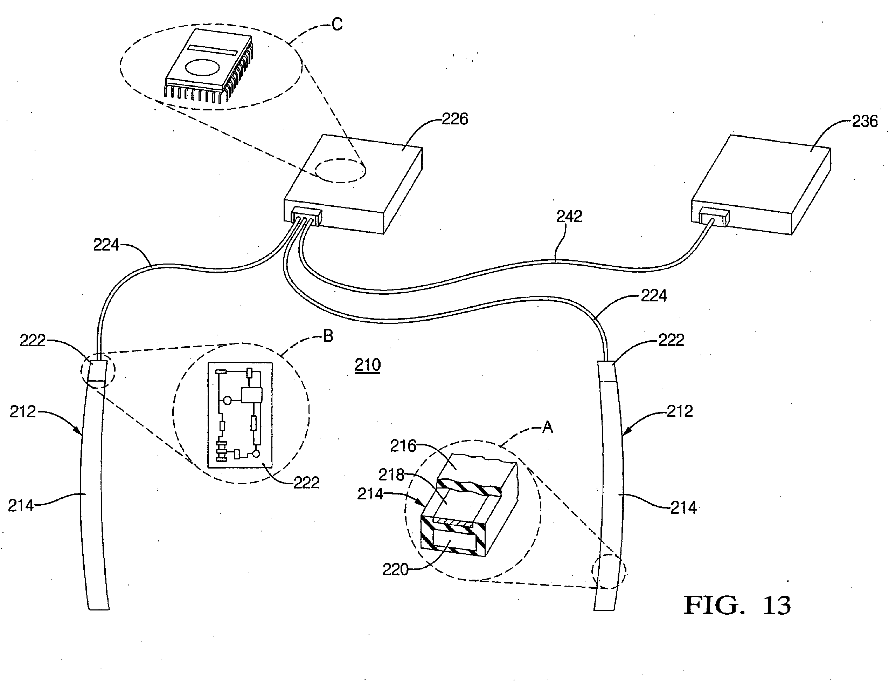

Referring now to Figures 13-20 a non-contact obstacle detection system that utilizes ultra sensitive capacitance techniques to control the movement of an electrically powered system such as power lift-gates, power sliding doors, power deck lids, or a moving door of a vehicle. Generally speaking, the system is based on an ultra sensitive capacitive detection technique, in which a proximity detection circuit is integrated directly into a capacitive sensing element. The capacitive sensing element may be embodied, for example, by a capacitive strip flexibly mounted to a metal panel such as a motor vehicle pillar or a lift-gate. When a foreign object (e.g., a human hand) comes in proximity to the sensor element while the powered door is closing, an electrical signal is generated by a central control module. This signal is then sent to another control module controlling the movement of the power lift-gate, causing the control module to stop the closing operation.

Referring initially to Figure 13, there is shown a schematic diagram of a non-contact obstacle detection system 210, in accordance with an embodiment of the invention. As stated previously, the non-contact system 210 is based upon ultra sensitive capacitance sensors and capacitance sensing techniques. Accordingly, system 210 includes one or more capacitive sensing elements 212, each configured to have a desired nominal capacitance value. Furthermore, each sensing element 212 is a flexible strip 214 designed to conform to a three-dimensional contoured surface, and to have a relatively low profile so as not to excessively protrude from the surface.

In general, each strip 214 has a flexible, elongated body with an adhesive surface affixed thereto for securing the strip 214 to a metal panel (e.g., a motor vehicle pillar lift-gate). As shown in the insert "A" in Figure 13, the sensor body may be formed by extruding an insulating, flexible material 216 (such as santoprene rubber) around a flat conductor 218 that serves as one electrode of the capacitive sensing element 212. The conductor 218 is designed to be substantially parallel to the panel along its entire surface when the strip is affixed to the panel. In one embodiment, the conductor 218 serves as one capacitor electrode, while the vehicle body serves as the other electrode. An air cavity 220 within the strip 214 serves, in one aspect, as a dielectric material between the capacitor electrodes. Alternatively, the sensing element 212 may be designed with two conductors molded internally therein. Additional details regarding the capacitive sensing element 212 are found in Figure 1-9 and as described herein.

Inserted within and coupled to each sensing element 212 is a proximity detection circuit 222, also referred to hereinafter as an ultra sensitive capacitance detector (USCD). The proximity detection circuit 222 (represented symbolically within insert "B" in Figure 13) senses a change in capacitance of its associated capacitive sensing element 212. In a preferred embodiment, the proximity detection circuit 222 operates by comparing a first frequency generated by a first oscillator to a reference frequency generated by a reference oscillator. The first frequency is dependent upon the capacitance value of the sensing element 212. As the capacitance value of the sensing element 212 changes (for example, due to a foreign object in proximity to the sensing element), so does the first frequency. The reference frequency remains fixed, and a differential output signal is generated which represents the difference in frequencies between the first frequency and the reference frequency. Additional information regarding a specific embodiment and capacitance detection method for the proximity detection circuit are found in Figures 1-12 and as described herein.

A coaxial cable 224 (or, alternatively a twisted pair of conductors) is used to transmit the differential output signal from each proximity detection circuit 222 within a sensing element 212 to a central control module 226. The frequency of the differential output signal may vary from about 3 to about 15 MHz, a relatively low frequency range for RF devices. Accordingly, the effect of radiated signals to any other electronic components in the vicinity of the cable 224 should be reduced. In contrast, the oscillators used in the proximity detection circuit 222 operate at relatively high frequencies (e.g., > 900 MHz) and are thus localized and shielded within the circuit 222.

It should be noted at this point that although a preferred frequency range for the oscillators is in the 900 MHz range, the system will work at any operating frequency. One advantage, however to operating above 900 MHz is the increased sensitivity of the circuit 222 to a change in capacitance. In addition, there is already an existing frequency band set by the FCC (between 902 to 928 MHz) for field disturbance sensing devices, which also covers the peak radiated power generated by the devices. Thus, operating the circuit at a different frequency range might result in additional time and costs in obtaining any necessary FCC approval.

A second purpose of the air cavity 220 within the sensing element strip 214, therefore, is to house the proximity detection circuit 222 so as to isolate the relatively high frequency signals generated therein. Further details regarding the integration of the proximity detection circuit 222 with the sensing element 12 are also found in Figures 11-12 and supporting descriptions.

In addition to transmitting the RF output signal, the cable 224 also carries a DC power signal (e.g., 5 volts) from the control module 226 to the corresponding USCD 222, thereby eliminating the need for individual power lines and RF signal lines. In order to send both DC and RF signals through a single line, a bias "T" apparatus is preferably provided for both the proximity detector circuit 222 and the central control module 226. As is known in the art, a bias "T" is generally used to couple a DC voltage onto a line used for AC (RF) signals, or to detect/remove the DC component of a composite signal. In a simple form, a bias "T" may include an inductive choke or, for frequencies exceeding 1 GHz, specifically tuned elements on a circuit board. Additional information on bias "T" arrangements may be found in U.S. Patent 6,229,408 to Jovanovich, et al. It will be appreciated that, if multiple sensing elements 212 are used in system 210, then the central control module 226 will include a multiple bias "T" arrangement.

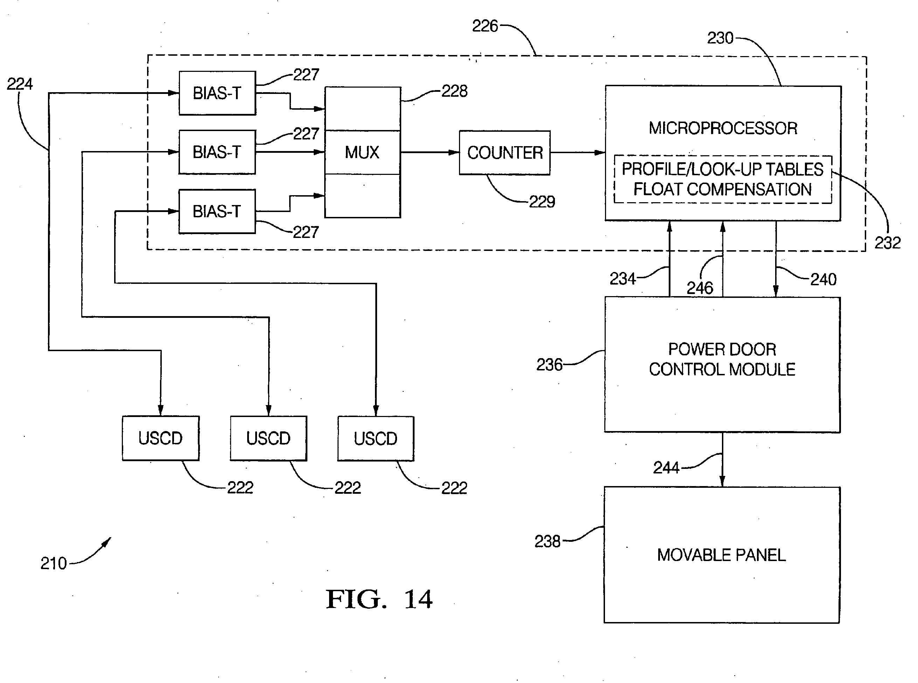

As is seen most particularly in the block diagram of Figure 14, the central control module 226 receives the differential output signals from each USCD 222. Again, a bias "T" arrangement 227 is provided for each USCD 227, and the input signals are sent through a multiplexer 228 and binary counter 229 to determine the specific frequency of each signal. The frequencies are converted into a digital representation thereof through a binary counter 229. A corresponding code (e.g., a 12-bit code) is thereby generated for use by a microprocessor 230 within the central control module 226. Software within the module 226, represented symbolically within insert "C" in Figure 13, is then used to compare the frequency value of a given differential output signal (from a particular sensing element 212 and corresponding USCD therein) to a nominal value stored in a profile or lookup table 232 to determine if an obstacle is present.

The profile table 232 preferably contains a nominal value for each discrete door position, as may be determined by an optical encoded output signal 234 generated by a power door control module 236. During the closing of a power door or moveable panel 238, it is conceivable, for example, that there could be a slightly increased capacitance detected by one or more proximity detection circuits 222 as a result of the door 238 approaching the sensing element(s) (in an embodiment in which at least one sensing element 212 is affixed to a stationary vehicle pillar). Thus, the system 210 is calibrated to compensate for such an increase, so as to distinguish approaching vehicle hardware from an actual object in proximity to the sensing elements 212.

When implemented in conjunction with a motor vehicle, the profile table 232 may be programmed generically to cover several vehicle designs or specifically for a particular vehicle design. However, the profile table 232 is preferably adapted to be automatically updated through the use of flash RAM or other suitable programmable memory structure. In addition, it is contemplated that system 210 is capable of being used as an obstacle detection system for other non-vehicular applications, for example an automotive door to a building or structure or a garage door.

In the event that a foreign object is in proximity to one or more sensing elements 212 within the obstacle detection system 210 during a door closing operation, the resulting differential output frequency from one or more of the sensing elements 212 will differ from that contained in the appropriate profile table. The microprocessor 230 within the central control module 226 will then send a signal 240 to the power door control module 236 through data line 242 (shown in Figure 1) which will cause the power door control module 236 to both stop and reverse the closing motion of the door 238 through signal 244.

In addition to sharing position information on the door/panel 238, the power door control module 236 may also be configured to provide an indication when the door 238 is in a fully closed position, through signal 246. Optionally, the central control module 226 could be expanded and integrated with the power door control module 236 to promote part reduction and cost savings. Other features may include a power saving or "sleep" mode in which the central control module 226 switches the power to each individual proximity detection circuit 222 off when the door 238 is in a fully closed position.

The software is further capable of compensating for environmental changes (such as the presence of water on the sensing elements 212), while still accurately detecting the presence of a foreign object, through the use of a floating variable routine. Because changes in temperature, humidity and other atmospheric conditions can have an effect on the system, a "floating variable" is added to the profile table value for each discrete door position. The floating variable will automatically increase or decrease, depending upon the specific environmental conditions or structural changes to the power door. Otherwise, an increase in capacitance of a sensing element 212 due to, for example, the presence of moisture thereon could be interpreted by the system 210 as a foreign object.

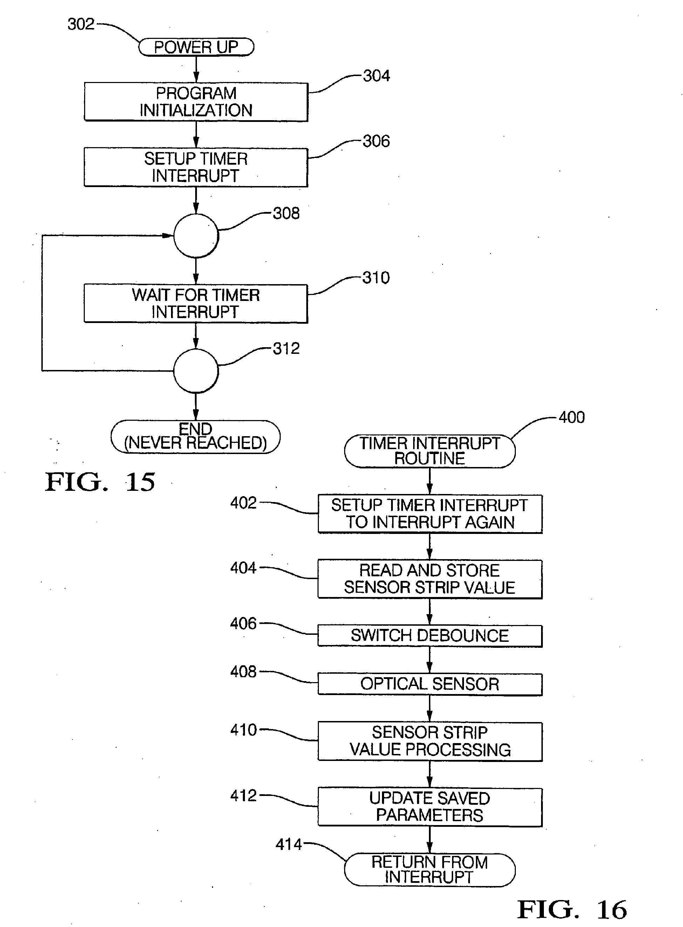

Figures 15 through 20 are flow diagrams that illustrate exemplary subroutines related to a floating variable algorithm for compensating for environmental and structural changes. Generally speaking, the environmental changes are compensated by a global floating variable having a value that increases or decreases over time as the current capacitance value deviates from a present profile value. The rate of change of the global floating variable is kept relatively slow so that a "fast" environmental change due to human interaction can be detected and distinguished from a true environmental change. Furthermore, the global floating variable applies to all points in the profile table.

On the other hand, the position floating variable includes a specific table of values that correspond to each position in the profile table. Each value is either incremented or decremented as the door moves through a position. If a difference is seen between the present position and the profile position value, then the position float variable is updated. This technique compensates for structural changes in the vehicle, such as door-to-body alignment or strut alignment, which in turn affect a portion of the profile table. Accordingly, the system adapts to physical changes in the door, which may vary from vehicle to vehicle depending on usage and/or damage to the door itself, which may physically affect the door while the door is still capable of opening and closing. Thus, as the door closes it and it's hardware can be sensed as obstacles. Therefore, the profile table lets the system know which sensed obstacles are the closing door and which are not. In addition, this profile table is updated as the physical or structural characteristics of the door changes. Thus, the system is adapted to detect physical changes to the door and other detectable hardware that may occur during the operational life of the same.

In Figure 15, there is shown a general routine implemented during the software system power up (block 302) and initialization steps (block 304). At block 306, a timer interrupt routine is set up. The timer interrupt routine, (indicated at node 308) is designed to begin the process of gathering input reading from one or more capacitive sensors, processing the gathered data, and updating the global and position float variables as necessary when the vehicle lift gate is being closed. By way of example, the timer interrupt duration is set for about 500 microseconds ($\mu$s). After waiting for the timer interrupt routine to be completed at block 310 and node 312, the process is sent back to node 308 for continuous repetition of the routine. Of course, and as applications may require, the timer interrupt duration can be greater or less than 500 microseconds.

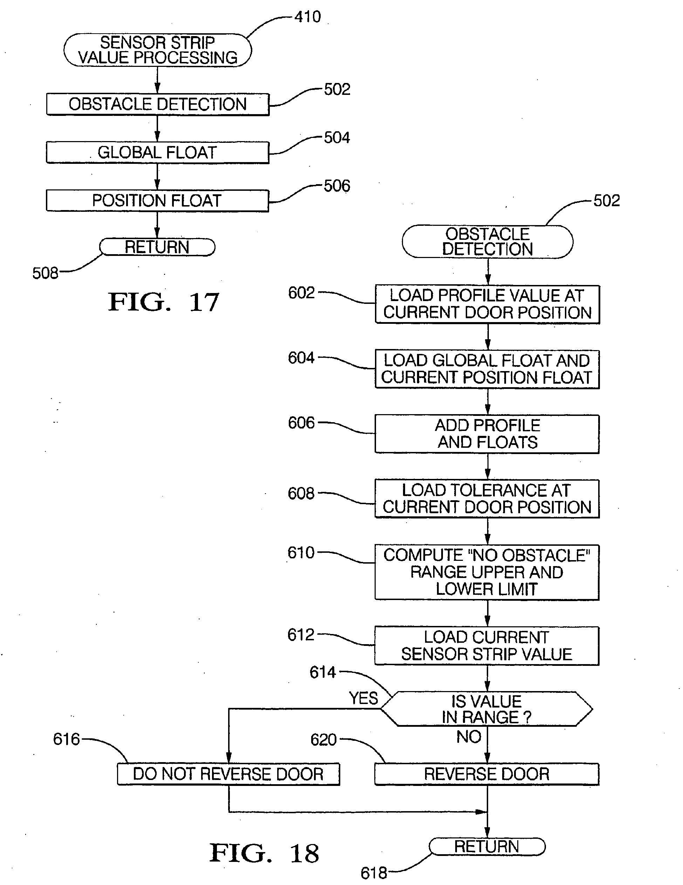

Figure 16 is another flow diagram that more specifically illustrates the steps implemented in the timer interrupt routine 400. At block 402, the Setup Timer Interrupt starts another data sample cycle, which will be used, in the next program cycle. The capacitive sensor strip values are then read and stored as shown at block 404. In addition, the lift gate position is continuously monitored as reflected in blocks 406 (providing switch debouncing for the lift gate latch) and 408 (optical position sensing). At block 410, the sensor strip values that were read and stored in block 404 are then processed as is described in greater detail in Figures 17 through 20. Any saved parameters such as global float variable or position float variables are stored in block 412 and the process return from the interrupt at block 414.

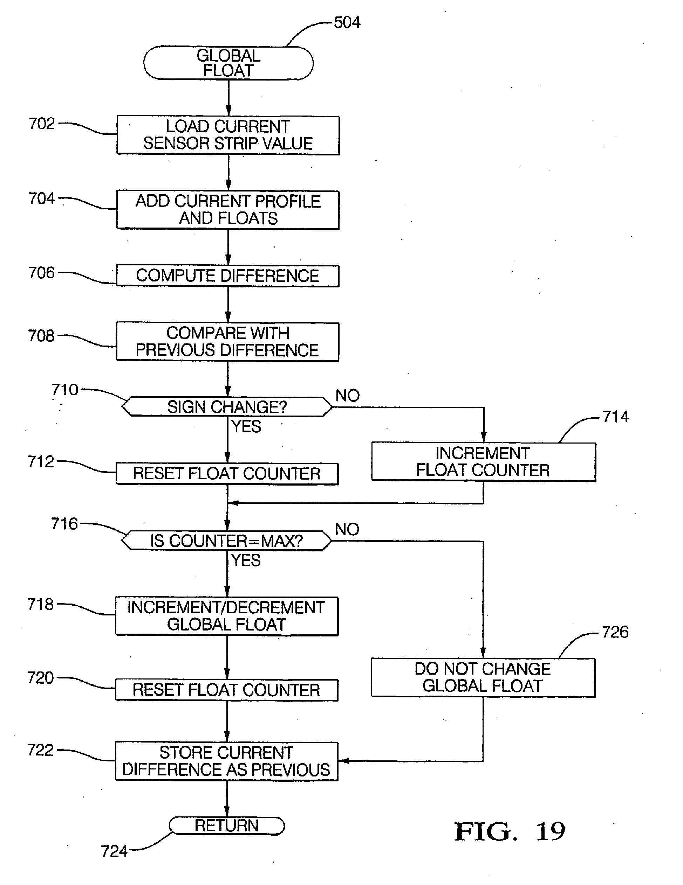

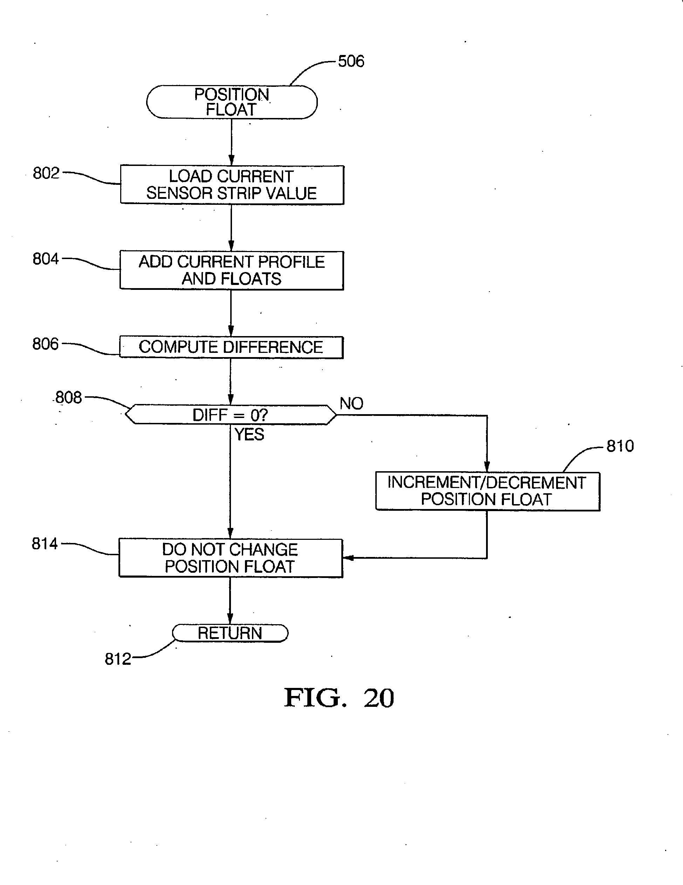

Referring now to Figure 17, the flow diagram therein generally illustrates the three general steps involved the sensor strip value processing block 410 in Figure 16. First, an obstacle detection routine is run at 502, and is described in further detail in Figure 18. Thereafter, a global float routine is run at block 504, and is described in further detail in Figure 19. Following the global float routine, a position float routine is run at block 506 (described in further detail in Figure 20) before returning back to block 412 in Figure 16.

Referring now to Figure 18, there is shown a more detailed flow diagram for the obstacle detection routine 502. Initially, at block 602, a profile value is loaded for the current door position occupied by the lift gate at that moment in time. The profile value is reflective of the digitized capacitance value that would signify no obstacle being present at that specific door position. Along with the profile value, the current global and position floats (as determined from those particular subroutines) are also loaded at block 604. At, block 606, the profile value is then added to the float values to result in an adjusted profile value that takes the floats into account. Then, a tolerance for the particular door position is loaded at block 608. The specific tolerance is door position dependent, and will help to establish a range of values for which it will be determined that no obstacle is present. This range is determined at block 610, where upper and lower limit values are computed for a "no obstacle" range.

Proceeding to block 612, the current sensor strip value is loaded for comparison to the upper and lower limits established in block 610. If the current value is within the range as determined at decision block 614, then no obstacle is deemed present, and no corrective action is taken with respect to the lift gate (i.e., the door is not reversed, as shown in block 616). The process returns to Figure 17, as shown at block 618. However, if the current value is not within the range as determined at decision block 614, then an obstacle is deemed present. A corrective action, for example a door reversal, is then commanded at block 620.

Again, after the obstacle detection routine 502 is executed as described above, a global float routine 504 is implemented. This is shown in the flow diagram of Figure 19. Global float routine 504 begins at block 702, where the current sensor strip value is loaded. Then, the current profile is added to the previously stored global and positional floats at block 704. A difference is then computed between the sum determined in block 704 and a reference value. At block 708, this difference is then compared with a previous difference determined from the preceding iteration of the global float routine 502. If at decision block 710 a sign change is determined, then a float counter is reset, as shown at block 712. If not, the float counter in incremented as shown at block 714.

Regardless of whether the float counter is incremented or reset, an inquiry is made at decision block 716 as to whether the float counter has reached a preset maximum value. If so, the routine proceeds to block 718 where the global float is either incremented or decremented, depending upon the conditions present. The float counter is then reset at block 720, and the current difference computed in block 706 is stored to be used as the "previous difference" value (block 708) for the next iteration. Alternatively, if at decision block 716, the counter has not reached the preset maximum value, the global float is not changed. This allows a slower transition of the global float value to adapt to environmental conditions, as described above. Even if the global float value is not changed the current difference is still stored at block 722, and the routine returns to Figure 17, as shown in block 724.

Finally, the position float routine 506 is illustrated in further detail in Figure 20. As any change in position float relates to the position of the door, the routine 506 is only run when a change in door position occurs. The current sensor strip value is loaded at block 802 and then added with the current profile and previous position float at block 804. It will be noted that the global float is not considered in this subroutine. Similar to the global float subroutine, the position float routine 502 then computes, at block 806, a difference between the sum determined in block 804 and a reference value from the preceding iteration of the routine. If a difference exists, then the position float is immediately changed (incremented or decremented) as reflected in block 810 before returning to Figure 17. If no difference exists, then the position float is not changed (block 814). However, in contrast to the global float routine, there is no position float counter.

It will be appreciated from the above described embodiments that the system 210 provides a means to detect the presence of an obstacle (such a human) in proximity a moving powered door, notwithstanding changes to the environment in which the sensing elements 212 are located.

**Claims**

1. An obstacle detection system (10) for a moveable item, comprising;

   a sensing element (12) disposed in proximity to the moveable item;
   a proximity detection (222) circuit in communication with said sensing element, said proximity detection circuit generating a differential output signal reflective of whether a foreign object is in proximity to said sensing element and;
   a central control module (226) in communication with said sensing element, said central control module determining whether said differential output signal is reflective of a foreign object in proximity to said sensing element;
   wherein, if said central control module determines that said differential output signal is reflective of a foreign object in proximity to said sensing element, and the moveable item is moving toward a closed position, then said central control module generates a control output signal to stop the moveable item from moving toward said closed position wherein a first oscillator (140) generates a first frequency signal, said first frequency signal dependant upon the capacitance of said sensing element; and
   a second oscillator (142) which generates a reference frequency signal; wherein said differential output signal is determined from a comparison between said first frequency signal and said reference frequency signal **characterised by** said sensing element comprising a longitudinal strip of insulating material (24) an elongated planar conductor (22) contained within an upper section of said longitudinal strip of insulating material, and a longitudinal cavity formed through a central portion of said longitudinal strip

2. The obstacle detection system of claim 1, wherein said central control module further comprises:

   a microprocessor (230);
   a multiplexer (228) for selectivity passing a selected differential output signal from each differential output signal imputed to said multiplexer; and
   software for comprising said selected differential output signal to a nominal value, said nominal value depending upon a specific position of the moveable item

3. The obstacle detection system of claim 1 or 2 wherein the moveable item is a door of a vehicle and the obstacle detection system, further comprises;

   a power door control module (236) in communication with said central control module,
   said power door control module controlling the movement of the door.

4. The obstacle detection system of any one of the preceding claims, wherein said sensing element further comprises a capacitive sensing element (212) having a nominal capacitance.

5. The obstacle detection system of claim 4, wherein said proximity detection circuit detects a change in said nominal capacitance as a result of a foreign object in proximity to said sensing element.

6. The obstacle detection system of any one of the preceding claims, wherein said proximity detection circuit is integrated within said sensing element.

7. The obstacle detection system of any one of the preceding claims, further comprising:

   a coaxial cable (224) coupling said proximity detection circuit and said central control module, said coaxial cable transmitting both a DC power signal and said differential output signal.

8. The obstacle detection system of any one of the preceding claims, wherein both said proximity detection circuit and said central control module further comprises a bias "T" apparatus (150) included herewith.

9. The obstacle detection system of any one of the preceding claims, wherein said differential output signal has a frequency range of about 0 Hz to about 15 MHz.

10. The obstacle detection system of any one of the preceding claims, wherein said first frequency signal and said reference frequency signal are generated at a frequency of at least 900 MHz.

11. The obstacle detection system of any one of the preceding claims, wherein said central control module further comprises;

a microprocessor (230); and
software for comprising said differential output signal to a nominal value, depending upon a specific position of the moveable item or door.

12. The obstacle detection system of claim 11, wherein said software further includes a floating variable routine (410) for compensating for environmental changes and structural changes proximate the moveable item or door.

13. The obstacle detection system of claim 12, wherein said floating variable routine further comprises a global float routine (504) and a position float routine (506), said global float routine being responsive to environmental changes and said position float routine being responsive to positional changes of the moveable item or door.

14. The obstacle detection system of claim 13, wherein said global float routine further includes a global float counter (504), said global float counter preventing a change in a given global float value until such time as said global float counter has reached a determined value.

15. The obstacle detection system of claim 12, wherein said floating variable routine comprises a global float routine (504) and a position float routine (506), said global float routine being responsive to environmental changes and said position float routine adaptive to structural changes to the moveable item or door.

16. The obstacle detection system of claim 12, wherein said position float routine is adaptive to structural changes to the moveable item or door, which occur during the operational life of the moveable item or door.

**Patentansprüche**

1. Hinderniserfassungssystem (10) für ein bewegliches Element, umfassend:

ein Erfassungselement (12) angeordnet in der Nähe des beweglichen Elements,
eine Näherungserfassungsschaltung (222) in Kommunikation mit dem Erfassungselement, wobei die Näherungserfassungsschaltung ein Differenzausgangssignal erzeugt, das darstellt, ob sich ein Fremdkörper in der Nähe des Erfassungselements befindet, und
ein zentrales Steuermodul (226) in Kommunikation mit dem Erfassungselement, wobei das zentrale Steuermodul bestimmt, ob das Differenzausgangssignal einen Fremdkörper in der Nähe des Erfassungselements anzeigt,
wobei, wenn das zentrale Steuermodul feststellt, dass das Differenzausgangssignal einen Fremdkörper in der Nähe des Erfassungselements anzeigt und sich das bewegliche Element zu einer Schließstellung bewegt, das zentrale Steuermodul ein Steuerausgangssignal erzeugt, um das bewegliche Element beim Bewegen zu seiner Schließposition zu stoppen, wobei ein erster Oszillator (140) ein erstes Frequenzsignal erzeugt, wobei das erste Frequenzsignal von der Kapazität des Erfassungselements abhängt, und
einen zweiten Oszillator (142), der ein Referenzfrequenzsignal erzeugt,
wobei das Differenzausgangssignal durch einen Vergleich zwischen dem ersten Frequenzsignal und dem Referenzfrequenzsignal bestimmt wird, **dadurch gekennzeichnet, dass** das Erfassungselement einen länglichen Streifen aus Isoliermaterial (24), einen länglichen ebenen Leiter (22), der in einem oberen Abschnitt des länglichen Streifens aus Isoliermaterial enthalten ist, und einen Längshohlraum aufweist, der durch einen zentralen Abschnitt des länglichen Streifens ausgebildet ist.

2. Hinderniserfassungssystem nach Anspruch 1, wobei das zentrale Steuermodul ferner Folgendes aufweist:

einen Mikroprozessor (230),
einen Multiplexer (228), um selektiv ein ausgewähltes Differenzausgangssignal von jedem Differenzausgangsignal, das dem Multiplexer zugewiesen ist, durchzugeben, und
Software zum Vergleichen des ausgewählten Differenzausgangssignals mit einem Nennwert, wobei der Nennwert von einer spezifischen Position des beweglichen Elements abhängt.

3. Hinderniserfassungssystem nach Anspruch 1 oder 2, wobei das bewegliche Element eine Tür eines Fahrzeugs ist, und wobei das Hinderniserfassungssystem ferner Folgendes aufweist:

ein Steuermodul (236) der angetriebenen Tür in Kommunikation mit dem zentralen Steuermodul,
wobei das Steuermodul für die angetriebene Tür die Bewegung der Tür steuert.

4. Hinderniserfassungssystem nach einem der vorhergehenden Ansprüche, wobei das Erfassungselement ferner ein kapazitives Erfassungselement (212) mit einer Nennkapazität aufweist.

5. Hinderniserfassungssystem nach Anspruch 4, wobei die Näherungserfassungsschaltung eine Änderung in der Nennkapazität als das Ergebnis eines Fremdkörpers in der Nähe des Erfassungselements erfasst.

6. Hinderniserfassungssystem nach einem der vorhergehenden Ansprüche, wobei die Näherungserfassungsschaltung in das Erfassungselement eingebaut ist.

7. Hinderniserfassungssystem nach einem der vorhergehenden Ansprüche, das ferner umfasst:

ein Koaxialkabel (224), das die Näherungserfassungsschaltung mit dem zentralen Steuermodul koppelt, wobei das Koaxialkabel sowohl ein Gleichstromsignal als auch das Differenzausgangssignal überträgt.

8. Hinderniserfassungssystem nach einem der vorhergehenden Ansprüche, wobei die Näherungserfassungsschaltung als auch das zentrale Steuermodul ferner ein "T"-Vorspanngerät (150) aufweisen, das hiermit enthalten ist.

9. Hinderniserfassungssystem nach einem der vorhergehenden Ansprüche, wobei das Differenzausgangssignal einen Frequenzbereich von etwa 0 Hz bis etwa 15 MHz hat.

10. Hinderniserfassungssystem nach einem der vorhergehenden Ansprüche, wobei das erste Frequenzsignal und das Referenzfrequenzsignal mit einer Frequenz von mindestens 900 MHz erzeugt werden.

11. Hinderniserfassungssystem nach einem der vorhergehenden Ansprüche, wobei das zentrale Steuermodul ferner umfasst:

einen Mikroprozessor (230), und Software zum Vergleichen des Differenzausgangssignals mit einem Nennwert je nach einer spezifischen Position des beweglichen Elements oder der Tür.

12. Hinderniserfassungssystem nach Anspruch 11, wobei die Software ferner ein Gleitvariablenhilfsprogramm (410) zum Kompensieren von Umgebungsänderungen und Strukturänderungen in der Nähe des beweglichen Elements oder der Tür aufweist.

13. Hinderniserfassungssystem nach Anspruch 12, wobei das Gleitvariablenhilfsprogramm ferner eine globale Gleitroutine (504) und eine Positionsgleitroutine (506) aufweist, wobei die globale Gleitroutine auf Umgebungsänderungen reagiert und die Positionsgleitroutine auf Positionsänderungen des beweglichen Elements oder der Tür reagiert.

14. Hinderniserfassungssystem nach Anspruch 13, wobei die globale Gleitroutine ferner einen globalen Gleitzähler (504) aufweist, wobei der globale Gleitzähler ein Ändern eines gegebenen globalen Gleitwerts verhindert, bis der globale Gleitzähler einen bestimmten Wert erreicht hat.

15. Hinderniserfassungssystem nach Anspruch 12, wobei das Gleitvariablenhilfsprogramm eine globale Gleitroutine (504) und eine Positionsgleitroutine (506) aufweist, wobei die globale Gleitroutine auf Umgebungsänderungen reagiert und sich das Positionsgleithilfsprogramm an Strukturänderungen an dem beweglichen Element oder der Tür anpasst.

16. Hinderniserfassungssystem nach Anspruch 12, wobei sich das Positionsgleithilfsprogramm an Strukturänderungen des beweglichen Elements oder der Tür anpasst, die während des Betriebslebens des beweglichen Elements oder der Tür auftreten.

## Revendications

1. Système de détection d'obstacles (10) destiné à un organe mobile, comprenant :

un élément de détection (12) disposé à proximité de l'organe mobile;
un circuit de détection de proximité (222) en communication avec ledit élément de détection, ledit circuit de détection de proximité générant un signal de sortie différentiel reflétant si un objet étranger se trouve à proximité dudit élément de détection et ;
un module de commande central (226) en communication avec ledit élément de détection, ledit module de commande central déterminant si ledit signal de sortie différentiel reflète qu'un objet étranger se trouve à proximité dudit élément de détection ;
dans lequel, si ledit module de commande central détermine que ledit signal de sortie différentiel reflète qu'un objet étranger se trouve à proximité dudit élément de détection, et que l'organe mobile se déplace en direction d'une position fermée, alors ledit module de commande central génère un signal de sortie de commande pour arrêter le déplacement de l'organe mobile en direction de ladite position fermée dans lequel un premier oscillateur (140) génère un premier signal de fréquence, ledit premier signal de fréquence dépendant de la capacitance dudit élément de détection ; et

un deuxième oscillateur (142) qui génère un signal de fréquence de référence ; dans lequel ledit signal de sortie différentiel est déterminé à partir d'une comparaison entre ledit premier signal de fréquence et ledit signal de fréquence de référence **caractérisé en ce que** ledit élément de détection comprend une bande longitudinale de matériau isolant (24) un conducteur planaire allongé (22) contenu à l'intérieur d'une section supérieure de ladite bande longitudinale de matériau isolant, et une cavité longitudinale formée à travers une partie centrale de ladite bande longitudinale.

2. Système de détection d'obstacles selon la revendication 1, dans lequel ledit module de commande central comprend en outre : un microprocesseur (230) ; un multiplexeur (228) permettant de passer sélectivement un signal de sortie différentiel sélectionné parmi chaque signal de sortie différentiel introduit audit multiplexeur ; et un logiciel permettant de comprendre ledit signal de sortie différentiel sélectionné à une valeur nominale, ladite valeur nominale dépendant d'une position spécifique de l'élément mobile.

3. Système de détection d'obstacles selon la revendication 1 ou 2, dans lequel l'organe mobile est une portière d'un véhicule et le système de détection d'obstacles comprend en outre : un module de commande de portière électrique (236) en communication avec ledit module de commande central, ledit module de commande de portière électrique commandant le déplacement de la portière.

4. Système de détection d'obstacles selon l'une quelconque des revendications précédentes, dans lequel ledit élément de détection comprend en outre un élément de détection capacitif (212) ayant une capacitance nominale.

5. Système de détection d'obstacles selon la revendication 4, dans lequel ledit circuit de détection de proximité détecte une variation dans ladite capacitance nominale par suite d'un objet étranger se trouvant à proximité dudit élément de détection.

6. Système de détection d'obstacles selon l'une quelconque des revendications précédentes, dans lequel ledit circuit de détection de proximité est intégré à l'intérieur dudit élément de détection.

7. Système de détection d'obstacles selon l'une quelconque des revendications précédentes, comprenant en outre un câble coaxial (224) reliant ledit circuit de détection de proximité et ledit module de commande central, ledit câble coaxial transmettant à la fois un signal d'alimentation à courant continu et ledit signal de sortie différentiel.

8. Système de détection d'obstacles selon l'une quelconque des revendications précédentes, dans lequel ledit circuit de détection de proximité et ledit module de commande central comprennent en plus tous les deux un appareil de type 'T' de polarisation (150) inclus dedans.

9. Système de détection d'obstacles selon l'une quelconque des revendications précédentes, dans lequel ledit signal de sortie différentiel a une plage de fréquences comprise entre environ 0 Hz et environ 15 MHz.

10. Système de détection d'obstacles selon l'une quelconque des revendications précédentes, dans lequel ledit premier signal de fréquence et ledit signal de fréquence de référence sont générés à une fréquence d'au moins 900 MHz.

11. Système de détection d'obstacles selon l'une quelconque des revendications précédentes, dans lequel ledit module de commande central comprend en outre :

un microprocesseur (230) ; et
un logiciel permettant de comprendre ledit signal de sortie différentiel à une valeur nominale, en fonction d'une position spécifique de l'organe mobile ou portière.

12. Système de détection d'obstacles selon la revendication 11, dans lequel ledit logiciel comprend en outre un programme à variables flottantes (410) permettant de compenser les variations environnementales et les variations structurelles à proximité de l'élément ou portière mobile.

13. Système de détection d'obstacles selon la revendication 12, dans lequel ledit programme à variables flottantes comprend en outre un programme à variables flottantes globales (504) et un programme à variables flottantes de position (506), ledit programme à variables flottantes globales étant sensible aux variations environnementales et ledit programme à variables flottantes de position étant sensible aux variations de position de l'organe mobile ou portière.

14. Système de détection d'obstacles selon la revendication 13, dans lequel ledit programme à variables flottantes globales comprend en outre un compteur à variables flottantes globales (504), ledit compteur à variables flottantes globales empêchant une variation d'une valeur flottante globale jusqu'au moment où ledit compteur de valeurs flottantes globales a atteint une valeur prédéterminée.

15. Système de détection d'obstacles selon la revendication 12, dans lequel ledit programme à variables flottantes comprend un programme à valeurs flottantes globales (504) et un programme à valeurs flottantes de position (506), ledit programme à variables flottantes globales étant sensible à des variations environnementales et ledit programme à valeurs flottantes de position s'adaptant aux variations structurelles de l'organe mobile ou portière.

16. Système de détection d'obstacles selon la revendication 12, dans lequel ledit programme à valeurs flottantes de position s'adapte aux variations structurelles de l'organe mobile ou portière, qui se produisent durant la durée de fonctionnement de l'organe mobile ou portière.

10

12

24

22

26

18

16

14

FIG. 1

10

24

12

22

14

26

28

18

16

20

FIG. 2 A

FIG. 2 B

FIG. 3

FIG. 4

FIG. 5

FIG. 6

FIG. 7

**FIG. 8**

**FIG. 9**

FIG. 10

FIG. 11

FIG. 12 A

FIG. 12 B

FIG. 13

EP 1 343 252 B1

FIG. 14

302 — POWER UP

PROGRAM
INITIALIZATION — 304

SETUP TIMER
INTERRUPT — 306

308

WAIT FOR TIMER
INTERRUPT — 310

312

END
(NEVER REACHED)

**FIG. 15**

TIMER INTERRUPT
ROUTINE — 400

402 — SETUP TIMER INTERRUPT
TO INTERRUPT AGAIN

404 — READ AND STORE
SENSOR STRIP VALUE

406 — SWITCH DEBOUNCE

408 — OPTICAL SENSOR

410 — SENSOR STRIP
VALUE PROCESSING

412 — UPDATE SAVED
PARAMETERS

414 — RETURN FROM
INTERRUPT

**FIG. 16**

SENSOR STRIP
VALUE PROCESSING —410

↓

OBSTACLE DETECTION —502

↓

GLOBAL FLOAT —504

↓

POSITION FLOAT —506

↓

RETURN

508—

## FIG. 17

OBSTACLE
DETECTION —502

↓

602— LOAD PROFILE VALUE AT
CURRENT DOOR POSITION

↓

604— LOAD GLOBAL FLOAT AND
CURRENT POSITION FLOAT

↓

606— ADD PROFILE
AND FLOATS

↓

608— LOAD TOLERANCE AT
CURRENT DOOR POSITION

↓

610— COMPUTE "NO OBSTACLE"
RANGE UPPER AND
LOWER LIMIT

↓

612— LOAD CURRENT
SENSOR STRIP VALUE

↓

614— IS VALUE
IN RANGE ?

YES → 616— DO NOT REVERSE DOOR

NO ↓

620— REVERSE DOOR

↓

RETURN

618—

## FIG. 18

504

GLOBAL
FLOAT

702 — LOAD CURRENT
SENSOR STRIP VALUE

704 — ADD CURRENT PROFILE
AND FLOATS

706 — COMPUTE DIFFERENCE

708 — COMPARE WITH
PREVIOUS DIFFERENCE

710 — SIGN CHANGE? — NO

YES

714

INCREMENT
FLOAT COUNTER

712 — RESET FLOAT COUNTER

716 — IS COUNTER=MAX? — NO

YES

718 — INCREMENT/DECREMENT
GLOBAL FLOAT

726

DO NOT CHANGE
GLOBAL FLOAT

720 — RESET FLOAT COUNTER

722 — STORE CURRENT
DIFFERENCE AS PREVIOUS

RETURN

724

FIG. 19

506

POSITION
FLOAT

802 — LOAD CURRENT
SENSOR STRIP VALUE

804 — ADD CURRENT PROFILE
AND FLOATS

806 — COMPUTE DIFFERENCE

808 — DIFF = 0?    NO

YES

810

INCREMENT/DECREMENT
POSITION FLOAT

814 — DO NOT CHANGE
POSITION FLOAT

RETURN

812

FIG. 20

## REFERENCES CITED IN THE DESCRIPTION

**Patent documents cited in the description**

- DE 2538531

- US 6229408 B, Jovanovich